# EUROPÄISCHE PATENTSCHRIFT

(11) **EP 3 571 209 B1**
(45) Veröffentlichungstag und Bekanntmachung des Hinweises auf die Patenterteilung: **28.06.2023**
(21) Anmeldenummer: 17825363.9
(22) Anmeldetag: 29.11.2017
(51) Int. Cl.: C07F 5/05, C07F 7/08, C08K 5/55, H10K 85/00, C09K 11/06

(54) **ARYLBORANBVERBINDUNG, VERFAHREN ZUR HERSTELLUNG DERSELBEN UND ORGANISCHE LEUCHTDIODE, DIE DIESE VERBINDUNG UMFASST**
ARYL BORANE COMPOUND, METHOD FOR THE PRODUCTION OF SAME, AND ORGANIC LIGHT-EMITTING DIODE COMPRISING SAID COMPOUND
COMPOSÉ DE TYPE ARYLBORANE, PROCÉDÉ POUR SA PRÉPARATION ET DIODE ÉLECTROLUMINESCENTE ORGANIQUE QUI COMPREND CE COMPOSÉ

(30) Priorität: 30.11.2016 DE 102016123099
(43) Veröffentlichungstag der Anmeldung: 27.11.2019
(73) Patentinhaber: Novaled GmbH, 01099 Dresden (DE)
(72) Erfinder: WAGNER, Matthias, 61194 Niddatal (DE); JOHN, Alexandra, 63150 Heusenstamm (DE); LERNER, Hans-Wolfram, 61440 Oberursel (DE)
(74) Vertreter: Erbacher, Martin
(86) Internationale Anmeldenummer: PCT/DE2017/101031
(87) Internationale Veröffentlichungsnummer: WO 2018/099520

(56) Entgegenhaltungen:
- CHRISTIAN REUS ET AL: "C-Functionalized, Air- and Water-Stable 9,10-Dihydro-9,10-diboraanthracenes: Efficient Blue to Red Emitting Luminophores", JOURNAL OF THE AMERICAN CHEMICAL SOCIETY, Bd. 135, Nr. 34, 28. August 2013 (2013-08-28), Seiten 12892-12907, XP55444895, US ISSN: 0002-7863, DOI: 10.1021/ja406766e in der Anmeldung erwähnt
- JINHUI CHEN ET AL: "Syntheses and Structures of 6,13-Dihydro-6,13-diborapentacenes: [pi]-Stacking in Heterocyclic Analogues of Pentacene", ORGANOMETALLICS, Bd. 27, Nr. 15, 1. August 2008 (2008-08-01), Seiten 3639-3641, XP055449226, US ISSN: 0276-7333, DOI: 10.1021/om8005068 in der Anmeldung erwähnt
- ALEXANDRA JOHN ET AL: "A Vicinal Electrophilic Diborylation Reaction Furnishes Doubly Boron-Doped Polycyclic Aromatic Hydrocarbons", ANGEWANDTE CHEMIE INTERNATIONAL EDITION, Bd. 56, Nr. 20, 12. April 2017 (2017-04-12), Seiten 5588-5592, XP055444889, ISSN: 1433-7851, DOI: 10.1002/anie.201701591
- SVEN KIRSCHNER ET AL: "How Boron Doping Shapes the Optoelectronic Properties of Canonical and Phenylene-Containing Oligoacenes: A Combined Experimental and Theoretical Investigation", CHEMISTRY - A EUROPEAN JOURNAL, Bd. 23, Nr. 21, 27. März 2017 (2017-03-27) , Seiten 5104-5116, XP055444891, DE ISSN: 0947-6539, DOI: 10.1002/chem.201700056
- JOHN ALEXANDRA ET AL: "Doubly boron-doped pentacenes as emitters for OLEDs", JOURNAL OF MATERIALS CHEMISTRY C, vol. 6, no. 40, 24 September 2018 (2018-09-24), pages 10881-10887, XP055777751, GB ISSN: 2050-7526, DOI: 10.1039/C8TC03954B Retrieved from the Internet: URL:https://pubs.rsc.org/en/content/articl epdf/2018/tc/c8tc03954b>
- John A: "Doubly boron-doped pentacenes as emitters for OLEDs - Electronic Supplementary Material", Electronic Supplementary Material (ESI) for Journal of Materials Chemistry C, 24 September 2018 (2018-09-24), pages 1-27, XP055777752, Retrieved from the Internet: URL:http://www.rsc.org/suppdata/c8/tc/c8tc 03954b/c8tc03954b1.pdf [retrieved on 2021-02-19]
- Lv Bo ET AL: "Synthesis, Single Crystal, and Physical Properties of Asymmetrical Thiophene/Selenophene-Fused Twistacenes", Chemistry - An Asian Journal, vol. 10, no. 12, 4 September 2015 (2015-09-04), pages 2677-2682, XP055938331, ISSN: 1861-4728, DOI: 10.1002/asia.201500733

## Beschreibung

Die vorliegende Erfindung betrifft eine Gruppe neuartiger Arylboranverbindungen, ein Verfahren zu deren Herstellung, eine organische Leuchtdiode, die eine solche Arylboranverbindung umfasst, sowie die Verwendung der Arylboranverbindungen.

Eine Vielzahl fluoreszierender Farbstoffe ist aus dem Stand der Technik bekannt. Ebenso ist die Verwendung solcher Farbstoffe in halbleitenden organischen Materialien, insbesondere in organischen Leuchtdioden (OLEDs), bekannt.

Für eine Anwendung in optoelektronischen Materialien ist es von besonderem Interesse, dass die eingesetzten Verbindungen neben einer Fluoreszenzwellenlänge im sichtbaren Bereich eine hohe Fluoreszenzquantenausbeute aufweisen und zusätzlich reversibel oxidierbar/reduzierbar sind. Um eine praktische Anwendung zu ermöglichen, ist es außerdem notwendig, dass die Materialien eine gute Löslichkeit in organischen Lösungsmitteln und eine Stabilität gegenüber Umwelteinflüssen (Sauerstoff, Luftfeuchtigkeit) besitzen.

Eine Vielzahl von Arylboranverbindungen, insbesondere auch Diboraanthracenverbindungen, sind aus dem Stand der Technik bekannt. In diesem Zusammenhang soll auf die folgenden Publikationen verwiesen werden:
A. Escande, M. J. Ingleson, Chem. Commun. 2015, 51, 6257.
M. Zhu, C. Yang, Chem. Soc. Rev. 2013, 42, 4963.
C. Hoffend, F. Schödel, M. Bolte, H.-W. Lerner, M. Wagner, Chem. Eur. J. 2012, 18, 15394.
C. Hoffend, M. Diefenbach, E. Januszewski, M. Bolte, H.-W. Lerner, M. C. Holthausen,
M. Wagner, Dalton Trans. 2013, 42,13826.
C. Reus, S. Weidlich, M. Bolte, H.-W. Lerner, M. Wagner, J. Am.Chem. Soc. 2013, 135, 12892.
C. Reus, F. Guo, A. John, M. Winhold, H.-W. Lerner, F. Jäkle, M. Wagner, Macromolecules 2014, 47, 3727.
J. Chen, J. W. Kampf, A. J. Ashe III, Organometallics 2008, 27, 3639.
C. Dou, S. Saito, K. Matsuo, I. Hisaki, S. Yamaguchi, Angew. Chem. Int. Ed. 2012, 51, 12206.
Z. Zhou, A. Wakamiya, T. Kushida, S. Yamaguchi, J. Am. Chem. Soc. 2012, 134, 4529.
V. M. Hertz, M. Bolte, H.-W. Lerner, M. Wagner, Angew. Chem. Int. Ed. 2015, 54, 8800.
Bo Lv et al., Chemistry- an Asian Journal, 2015, 10, 2677.
J. Alexandra et al. Journal of Materials Chemistry C 2018, 6(40) 10881.
J. Alexandra et al. Journal of Materials Chemistry C 2018, Seiten 1 bis 27.

Die aus dem Stand der Technik bekannten Arylboranverbindungen weisen meist Fluoreszenzeigenschaften auf, deren Effizienz allerdings oft für eine Anwendung unzulänglich ist.

Es ist daher, vor dem Hintergrund des Stands der Technik, die Aufgabe der vorliegenden Erfindung, Verbindungen bereitzustellen, die Nachteile des Stands der Technik überwinden, insbesondere neuartige Arylboranverbindungen bereitzustellen, die als Fluoreszenzfarbstoff eingesetzt werden können und eine hohe Effizienz (Fluoreszenzquantenausbeute) haben. Ebenso sollen Verbindungen bereitgestellt werden, die verbesserte Ladungstransporteigenschaften aufweisen.

Eine weitere Aufgabe der vorliegenden Erfindung ist es, ein Verfahren zur Herstellung neuartiger Arylborane bereitzustellen, das Nachteile des Stands der Technik überwindet, insbesondere die Synthese asymmetrischer, aromatischer Verbindungen erlaubt, wobei insbesondere die Herstellung von Diboraanthracenderivaten ermöglicht werden soll, in denen zwei unterschiedliche aromatische Gruppen durch zwei borhaltige Brücken verbunden werden. Der Erfindung liegt ferner die Aufgabe zugrunde, in wenigen Stufen, ausgehend von preiswerten bzw. kommerziell erhältlichen Ausgangsstoffen eine Vielzahl an Luminophoren bereitzustellen.

Die Aufgaben werden gelöst durch den Gegenstand der unabhängigen Ansprüche. Weitere Ausführungsformen werden in den Unteransprüchen beschrieben.

Diese Aufgabe wird gelöst durch eine Verbindung der allgemeinen Formel 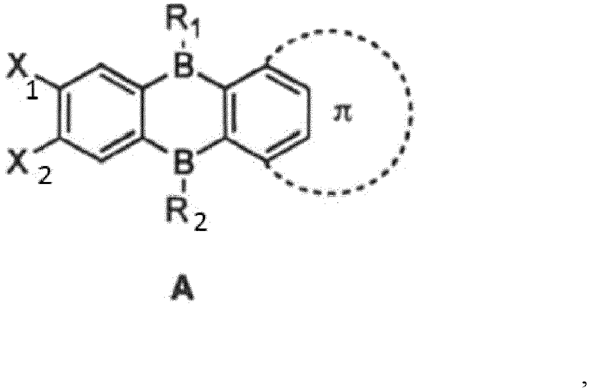
wobei X₁ und X₂ unabhängig voneinander ausgewählt sind aus der Gruppe, bestehend aus H, Cl, unsubstituiertem Thiophen und Thiophen, das mit einer oder mehreren Alkylgruppen substiutiert ist;
R₁ und R₂ unabhängig voneinander ausgewählt sind aus alkylsubstituierten Phenylgruppen,
wobei die gestrichelte Linie zusammen mit der Phenylgruppe, die mit den Enden der gestrichelten Linie verbunden ist, eine anellierte, aromatische Gruppe darstellt.

Die dargestellten Verbindungen der gestrichelten Linie mit der Phenylgruppe stellen hierbei nicht zwingend die tatsächliche Bindung des restlichen Teils der anellierten, aromatischen Gruppe an die Phenylgruppe dar. Vielmehr ist vorzugsweise vorgesehen, dass weitere aromatische Ringe, die an die Phenylgruppe anelliert sind, über zwei benachbarte Kohlenstoffatome der Phenylgruppe mit dieser verbunden sind. Die Anellierung erfolgt also vorzugsweise über ein erstes Kohlenstoffatom und ein zweites Kohlenstoffatom, das in *ortho-*Position zu dem ersten Kohlenstoffatom angeordnet ist. Als einfachste, beispielhafte Verbindung in diesem Zusammenhang sei Naphthylen genannt.

Es kann bevorzugt vorgesehen sein, dass die Alkylgruppe(n), mit denen die Phenylgruppe substituiert ist, ausgewählt ist aus C₁-C₆-Alkyl, d.h. aus einer verzweigten oder unverzweigten Alkylgruppe mit 1 bis 6 Kohlenstoffatomen.

Eine anellierte Verbindung im Sinne der vorliegenden Erfindung ist eine Verbindung, die durch Anellierung, bzw. Kondensation, eines Ringes an einen oder mehrere schon vorhandene Ringe eines zyklischen Moleküls erhalten wird. Dabei sind zumindest zwei Ringglieder gleichzeitig Bestandteil zweier Ringe.

Eine aromatische Verbindung im Sinne der vorliegenden Erfindung ist eine Verbindung, die zumindest ein Ringsystem umfasst, das nach der Hückel-Regel in konjugierten Doppelbindungen, freien Elektronenpaaren und unbesetzten p-Orbitalen einer Anzahl von 4n+2 (n=0, 1, 2, ...) delokalisierter Elektronen enthält.

Beispielhafte und bevorzugte erfindungsgemäße anellierte, aromatische Gruppen sind Naphthylen, Anthracenylen, 9,10-Diphenylanthracenylen, Phenanthrenylen, Biphenylenylen, Fluorenylen, 9,10-Dihydroanthracenylen, Fluoranthenylen, Benzo[a]pyrenylen, Dibenzo[c,g]phenanthrenylen, Tetracenylen, 9,9`-Bianthracenylen oder Benzo[b]biphenylenylen.

Für diese Verbindungen konnten herausragende Fluoreszenzeigenschaften, insbesondere geeignete Fluoreszenzwellenlängen und Fluoreszenzquantenausbeuten, beobachtet werden. Ebenso wurde für die bevorzugten anellierten, aromatischen Gruppen eine vorteilhafte erfindungsgemäße reversible Oxidierbarkeit/Reduzierbarkeit beobachtet.

Die Endung "...ylen" definiert erfindungsgemäß die Bindungen der anellierten, aromatischen Gruppe in dem Molekül der Formel A, nämlich durch zwei kovalente Bindungen zu jeweils einem der zwei Boratome. Erfindungsgemäß ist vorgesehen, dass die anellierte, aromatische Gruppe mittels kovalenter Bindungen zu den Boratomen mit diesen verbunden ist, wobei die kovalenten Bindungen an zwei benachbarten Kohlenstoffatomen der anellierten, aromatischen Gruppe angeordnet sind.

Es ist vorgesehen, dass X₁ und X₂ unabhängig voneinander ausgewählt sind aus H, Cl unsubstituiertem Thiophen oder Thiophen, das mit einer oder mehreren Alkylgruppen substiutiert ist. Bevorzugt ist Thiophen, das mit lediglich einer Alkylgruppe substituiert ist. Bevorzugt ist hierbei, dass die Alkylgruppe mit einem Kohlenstoffatom, das dem Schwefelatom benachbart ist, verbunden ist. Bevorzugt vorgesehen ist in diesem Zusammenhang, dass die Alkylgruppe Methyl ist. Die Wahl von X₁ und X₂ als Cl ermöglicht eine einfache Herstellung der erfindungsgemäßen Verbindung. Ferner wird durch die Wahl von Cl die weitere Funktionalisierung der Verbindung A mit elektronenreichen Aromaten (z.B. Thiophen) ermöglicht, um die optoelektronischen Eigenschaften der Verbindung weiter zu modifizieren. Für die Wahl von Thiophen als zumindest eine der Gruppen X₁ oder X₂ konnten besonders hervorragende optoelektronische Eigenschaften beobachtet werden.

Ebenso ist vorgesehen, dass R₁ und R₂ unabhängig voneinander ausgewählt sind aus alkylsubstituierten Phenylgruppen, vorzugsweise Mesityl und/oder 2,4,6-Tri(isopropyl)phenyl. Durch diese bevorzugte Wahl der Substituenten R₁ und R₂ konnte eine besonders hohe Stabilität der Verbindung der allgemeinen Formel A erreicht werden.

Die Aufgabe der Erfindung wird ferner gelöst durch ein hochmodulares Verfahren zur Herstellung einer erfindungsgemäßen Verbindung, umfassend die Schritte:
a) Umsetzen einer Verbindung der Formel 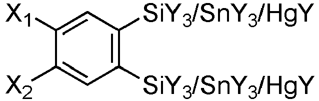
   wobei jedes Y unabhängig ausgewählt ist aus der Gruppe, bestehend aus H, Alkyl und Aryl,
   mit einer anellierten, aromatischen Verbindung und BBr₃, um ein Zwischenprodukt zu erhalten; und
b) Umsetzen des Zwischenprodukts mit R₁MgBr, R₁Li, R₁Cu, R₁-Zn-R₁, R₁-Cd-R₁, R₁-Hg-R₁, (R₁)₃-Bi, (R₁)₃-Sb oder einem Gemisch derselben und/oder R₂MgBr, R₂Li, R₂Cu, R₂-Zn-R₂, R₂-Cd-R₂, R₂-Hg-R₂, (R₂)₃-Bi, (R₂)₃-Sb oder einem Gemisch derselben, um die erfindungsgemäße Verbindung zu erhalten.

Das Umsetzen der beschriebenen Verbindungen in den Schritten a) und b) bezeichnet erfindungsgemäß das Reagieren der genannten Verbindungen miteinander. Die Umsetzung kann hierbei in Gegenwart geeigneter Lösungsmittel, üblicher Hilfsreagenzien, erhöhten oder abgesenkten Temperaturen, unter Verwendung üblicher Reaktionsgefäße etc. erfolgen. Geeignete Reaktionsbedingungen sind dem Fachmann wohlbekannt und werden von diesem in geeigneter Weise auf Grundlage seines allgemeinen Fachwissens ausgewählt. Beispielhafte Reaktionsbedingungen werden in dieser Anmeldung anhand konkreter Beispiele gezeigt. Die mittels des erfindungsgemäßen Verfahrens erhaltenen Zwischen- und Endprodukte können ferner mittels üblicher Aufreinigungsschritte (Destillation, Chromatographie, Kristallisation, etc.) aufgereinigt werden.

Das in dem erfindungsgemäßen Verfahren erhaltene Zwischenprodukt weist hierbei die folgende allgemeine Formel auf.

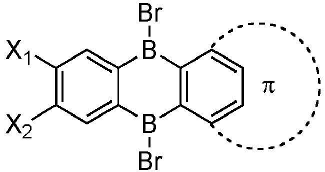

Die anellierte, aromatische Verbindung, die im Schritt a) des erfindungsgemäßen Verfahrens eingesetzt wird, ist später als anellierte, aromatische Gruppe in der erfindungsgemäßen Verbindung enthalten. Bevorzugte anellierte, aromatische Verbindungen zur Verwendung in dem Verfahren sind Naphthalin, Anthracen, 9,10-Diphenylanthracen, Phenanthren, Biphenylen, Fluoren, 9,10-Dihydroanthracen, Fluoranthen, Benzo[a]pyren, Dibenzo[c,g]phenanthrenylen, Tetracen, 9,9`-Bianthracen und Benzo[b]biphenylen.

Vorzugsweise erfolgt die Umsetzung in Schritt b), nämlich die Umsetzung des Zwischenprodukts mit R_{1/2}MgBr, R_{1/2}Li, R_{1/2}Cu, R_{1/2}-Zn-R_{1/2}, R_{1/2}-Cd-R_{1/2}, R_{1/2}-Hg-R_{1/2}, (R_{1/2})₃-Bi, (R_{1/2})₃-Sb oder einem Gemisch derselben in Gegenwart organischer Lösungsmitteln wie Toluol, n-Alkanen oder Diethylether.

Darüber hinaus wird die Aufgabe gelöst durch eine organische Leuchtdiode, umfassend eine erfindungsgemäße Verbindung.

Hierbei ist vorzugsweise vorgesehen, dass die organische Leuchtdiode eine Emissionsschicht umfasst und die erfindungsgemäße Verbindung in der Emissionsschicht angeordnet ist.

Schließlich wird die Aufgabe gelöst durch die Verwendung der erfindungsgemäßen Verbindung als Fluoreszenzfarbstoff. Weitere potentielle Verwendungen, die die gestellte Aufgabe lösen, ist eine Verwendung als Elektrolumineszenzmittel oder in organischen n-Typ Halbleitern.

Überraschenderweise wurde durch die Erfinder festgestellt, dass die erfindungsgemäßen Verbindungen hohe Fluoreszenzquantenausbeuten, die solche des Stands der Technik übersteigen, aufweisen. Ebenfalls wurde durch die Erfinder gefunden, dass die erfindungsgemäßen Verbindungen günstige Ladungstransporteigenschaften aufweisen. Diese Eigenschaften ermöglichen den Einsatz der erfindungsgemäßen Verbindungen in organischen Leuchtdioden und ähnlichen Vorrichtungen. Ebenso wurde durch die Erfinder ein Verfahren bereitgestellt, in denen die erfindungsgemäßen Verbindungen in einer einfachen, kurzen und flexiblen Reaktionsführung ausgehend von leicht zugänglichen bzw. kommerziell erhältlichen Ausgangstoffen hergestellt werden können. Diese hochmodulare Vorgehensweise ermöglicht industriefreundliches Screeningverfahren.

Die Erfindung beinhaltet die neuartigen Arylborane des Strukturtyps **A**, welche sich über eine innovative Kaskadenreaktion, SiB-Austausch kombiniert mit elektrophiler Borylierung, darstellen lassen. Die dadurch erstmalig hergestellten Bor-dotierten, asymmetrischen, polyzyklischen aromatischen Kohlenwasserstoffe (kurz: PAKs) zeichnen sich unter anderem durch ihre hervorragenden optoelektronischen Eigenschaften aus. Bei Strukturen des Typs **A** sind die Substituenten R₁ und R₂ eine alkylsubstituierte Phenylgruppe, insbesondere Mesityl oder 2,4,6-Tri(isopropyl)phenyl. Neben der Herstellung dieser Verbindungen ist ihre Verwendung in elektronischen und optoelektronischen Materialien vorgesehen.

Die bisher hergestellten Derivate zeigen sowohl vorteilhafte optische als auch elektronische Eigenschaften, die einen Einsatz in der Optoelektronik ermöglichen. Neben einer ausgeprägten Fluoreszenz im grün-blauem Bereich, konnte mittels Cyclovoltammetrie die reversible Reduzierbarkeit aufgezeigt werden, was für eine besonders gute Elektronenleitung mit hoher Lebensdauer spricht. Zusätzlich zu diesen optoelektronischen Eigenschaften sind die bisher dargestellten Derivate stabil gegenüber Luft und Feuchtigkeit, was sie von vielen bekannten Organoboranen unterscheidet und eine Anwendung in OLEDs ermöglicht. Die gute Löslichkeit der dargestellten Verbindungen in organischen Lösungsmitteln schafft die Voraussetzung für eine Fertigung mittels Drucktechnik. Darüber hinaus erschließt diese Kaskadenreaktion die Darstellung einer Vielzahl von Fluoreszenzfarbstoffen mit definierten und im Hinblick zu bisher verwendeten Farbstoffen verbesserten Eigenschaften.

Die Synthese von Verbindungen des Typs **A** ist im Folgenden am Beispiel des aus Naphthalin hergestellten PAHs beschrieben. Als Ausgangsverbindung wird zunächst 1,2-Dichlor-4,5-bis(trimethylsilyl)benzol in einer bekannten zweistufigen Synthese hergestellt (A. Lorbach, C. Reus, M. Bolte, H.-W. Lerner, M. Wagner, Adv. Synth. Catal. 2010, 352, 3443). Die Umsetzung von dieser Verbindung mit dem entsprechenden Aromat und BBr₃ stellt den Schlüsselschritt der Synthesesequenz dar. Hierbei kommt es zu einem SiB-Austausch, gefolgt von der Einführung der beiden Boratome am Naphthalingerüst über eine elektrophile aromatische Substitution (Borylierung). Durch die Verwendung von unterschiedlichen polyzyklischen aromatischen Kohlenwasserstoffen lässt sich hierbei das π-System des darzustellenden Arylboranes beliebig variieren. Die anschließende Einführung von Mesityl-Schutzgruppen erfolgt *in-situ* und ist eine gängige Methode zur Abschirmung des leeren p_{z}-Orbitals am Boratom, sodass eine Stabilität gegenüber Sauerstoff und Feuchtigkeit gewährleistet ist.

Die Erfindung soll im Folgenden anhand konkreter Beispiele unter Bezugnahme auf die Figuren erläutert werden. Die Figuren zeigen die folgenden Gegenstände.

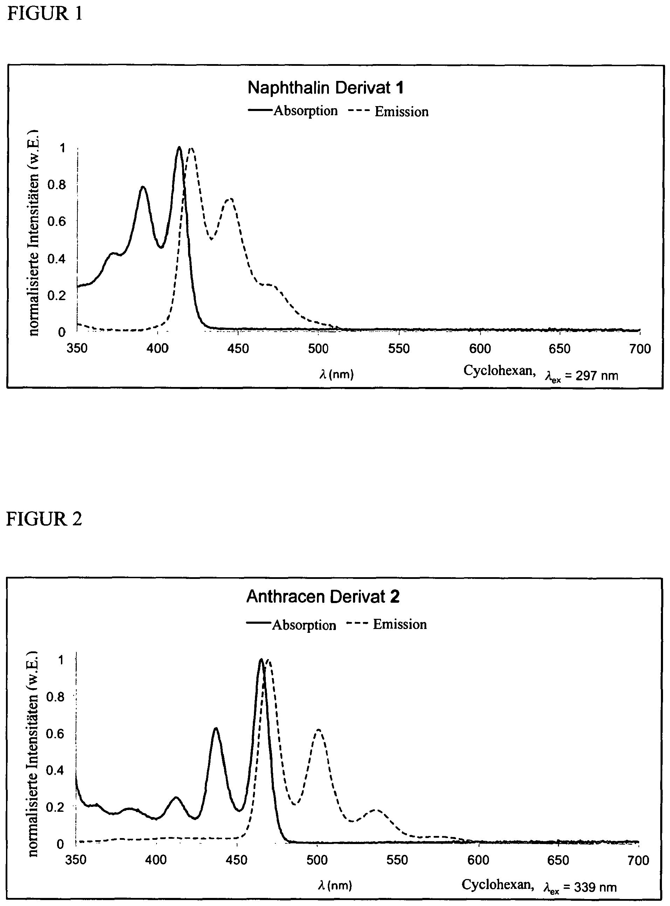

- Figur 1:: Normalisiertes UV-Absorptions- und Emissionsspektrum des Naphthalin Derivates **1** in Cyclohexan.
- Figur 2:: Normalisiertes UV-Absorptions- und Emissionsspektrum des Anthracen Derivates **2** in Cyclohexan.

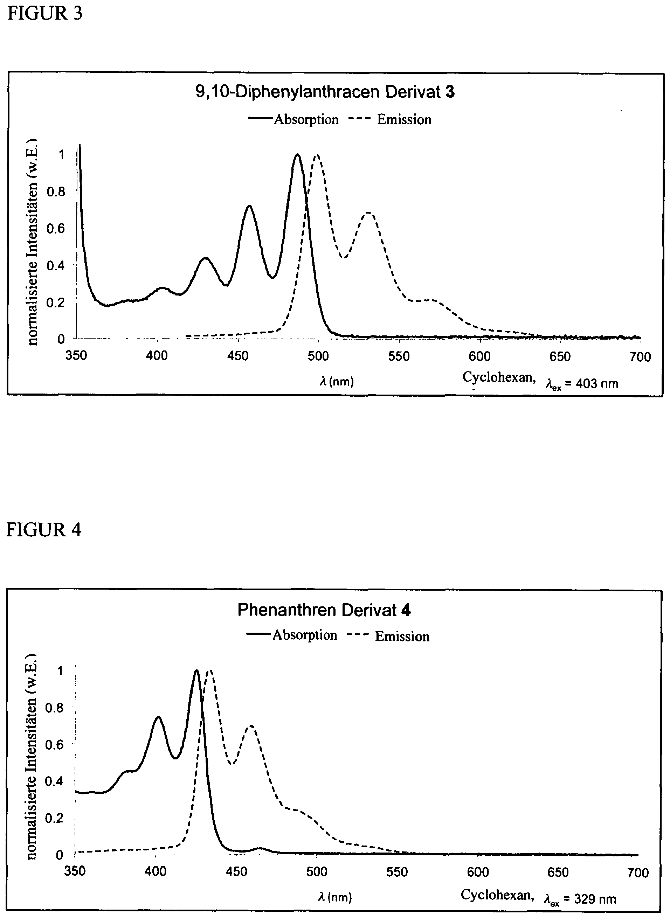

- Figur 3:: Normalisiertes UV-Absorptions- und Emissionsspektrum des 9,10-Diphenylanthracen Derivates 3 in Cyclohexan.
- Figur 4:: Normalisiertes UV-Absorptions- und Emissionsspektrum des Phenanthren Derivates 4 in Cyclohexan.

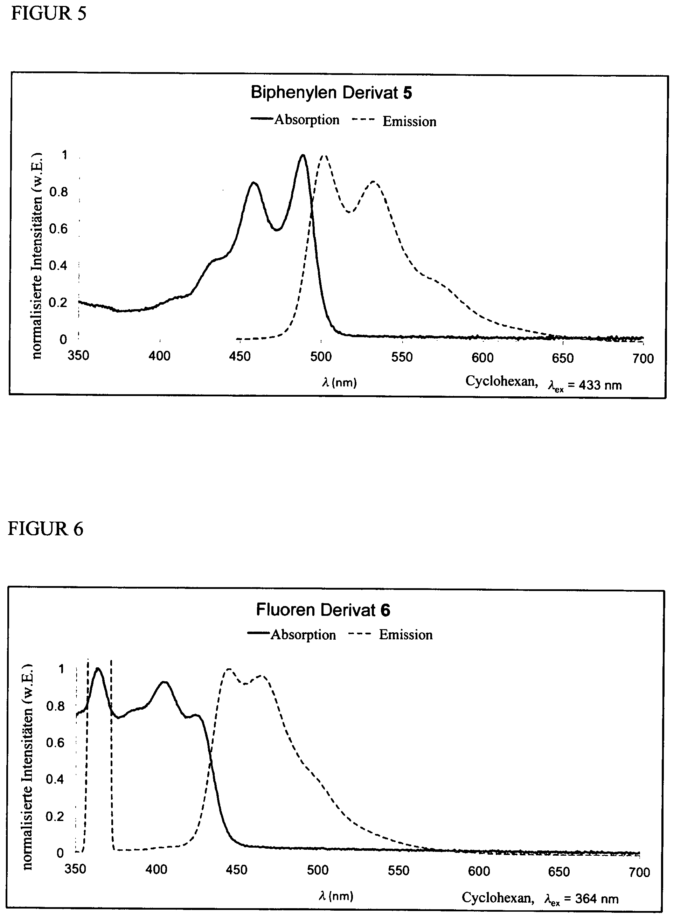

- Figur 5:: Normalisiertes UV-Absorptions- und Emissionsspektrum des Biphenylen Derivates **5** in Cyclohexan.
- Figur 6:: Normalisiertes UV-Absorptions- und Emissionsspektrum des Fluoren Derivates **6** in Cyclohexan.

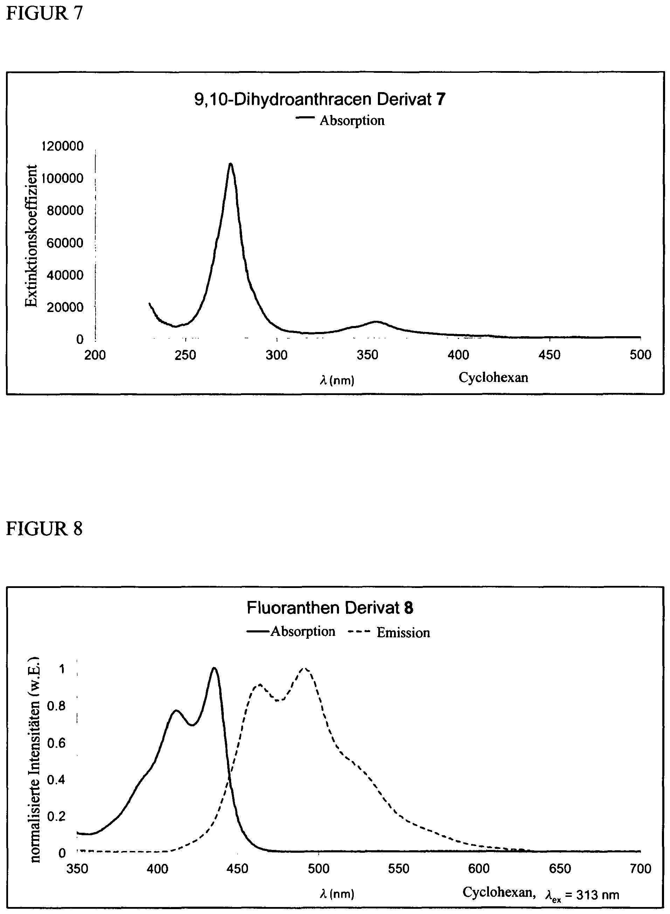

- Figur 7:: Normalisiertes UV-Absorptionsspektrum des 9,10-Dihydroanthracen Derivates **7** in Cyclohexan.
- Figur 8:: Normalisiertes UV-Absorptions- und Emissionsspektrum des Fluoranthen Derivates **8** in Cyclohexan.

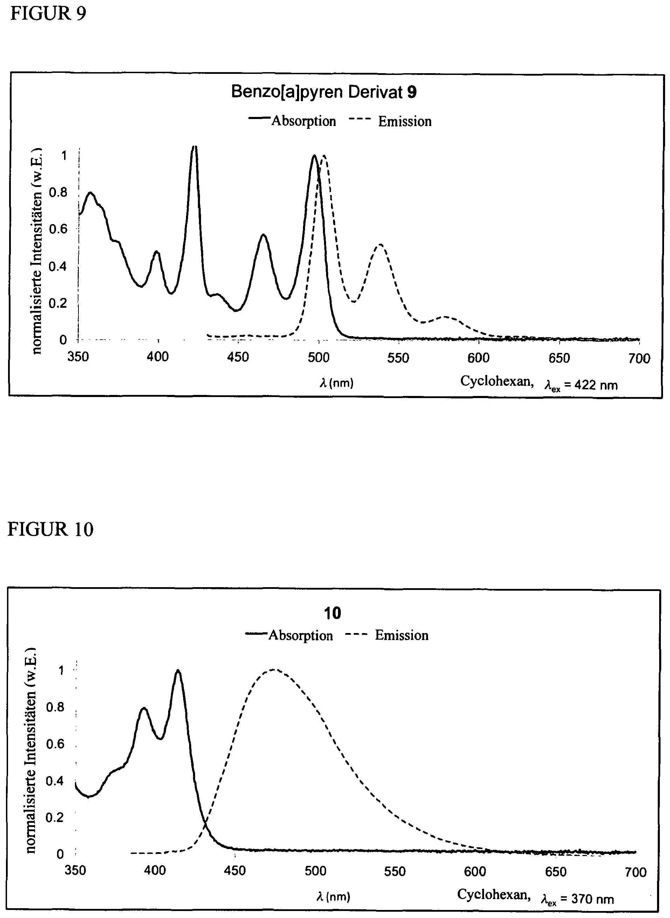

- Figur 9:: Normalisiertes UV-Absorptions- und Emissionsspektrum des Benzo[a]pyren Derivates **9** in Cyclohexan.
- Figur 10:: Normalisiertes UV-Absorptions- und Emissionsspektrum der Verbindung **10** in Cyclohexan.

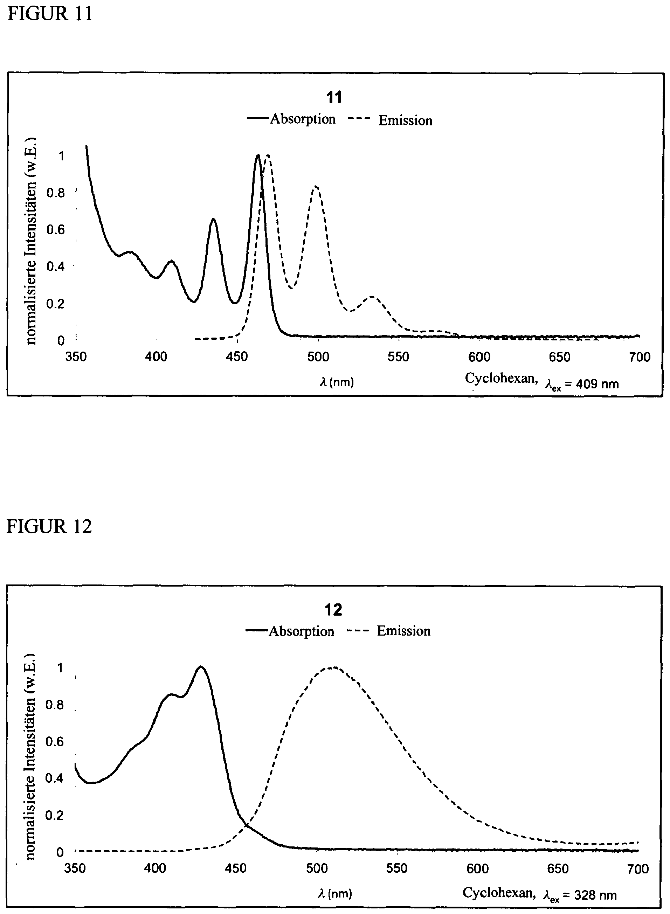

- Figur 11:: Normalisiertes UV-Absorptions- und Emissionsspektrum der Verbindung **11** in Cyclohexan.
- Figur 12:: Normalisiertes UV-Absorptions- und Emissionsspektrum der Verbindung **12** in Cyclohexan.

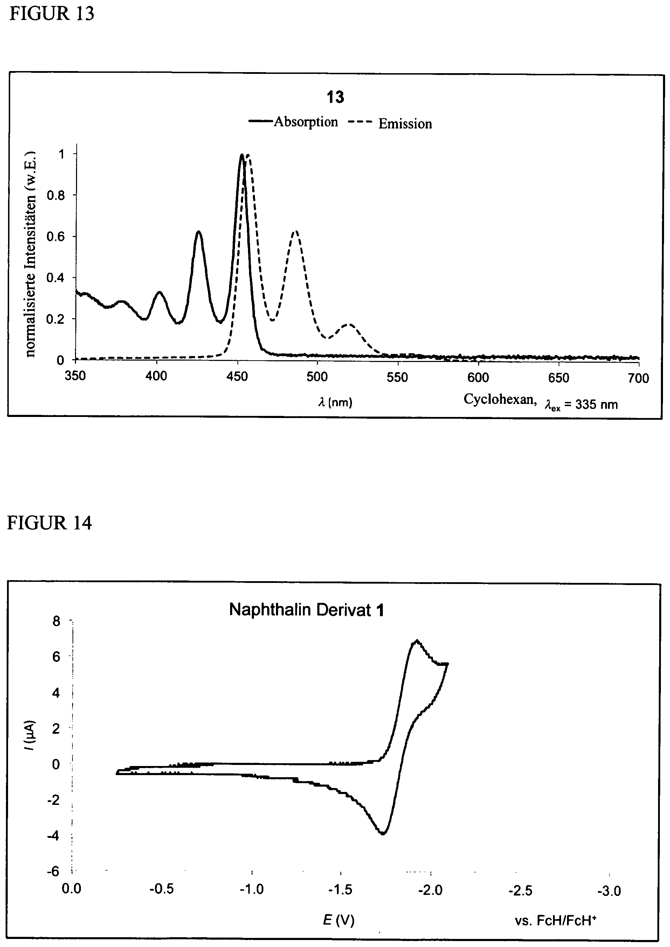

- Figur 13:: Normalisiertes UV-Absorptions- und Emissionsspektrum der Verbindung **13** in Cyclohexan.
- Figur 14:: Cyclovoltammogramm des Naphthalin Derivates **1** (CH₂Cl₂, [*n*Bu₄N][PF₆] 0.1 M, 200 mV s⁻¹).

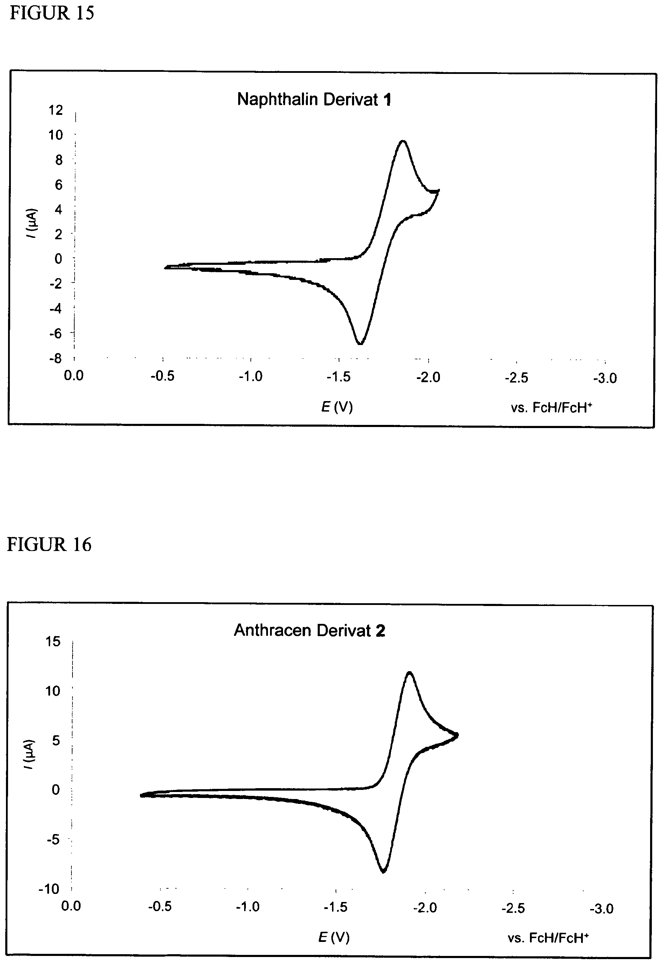

- Figur 15:: Cyclovoltammogramm des Naphthalin Derivates **1** (THF, [*n*Bu₄N][PF₆] 0.1 M, 200 mV s⁻¹).
- Figur 16:: Cyclovoltammogramm des Anthracen Derivates **2** (CH₂Cl₂, [*n*Bu₄N][PF₆] 0.1 M, 200 mV s⁻¹).

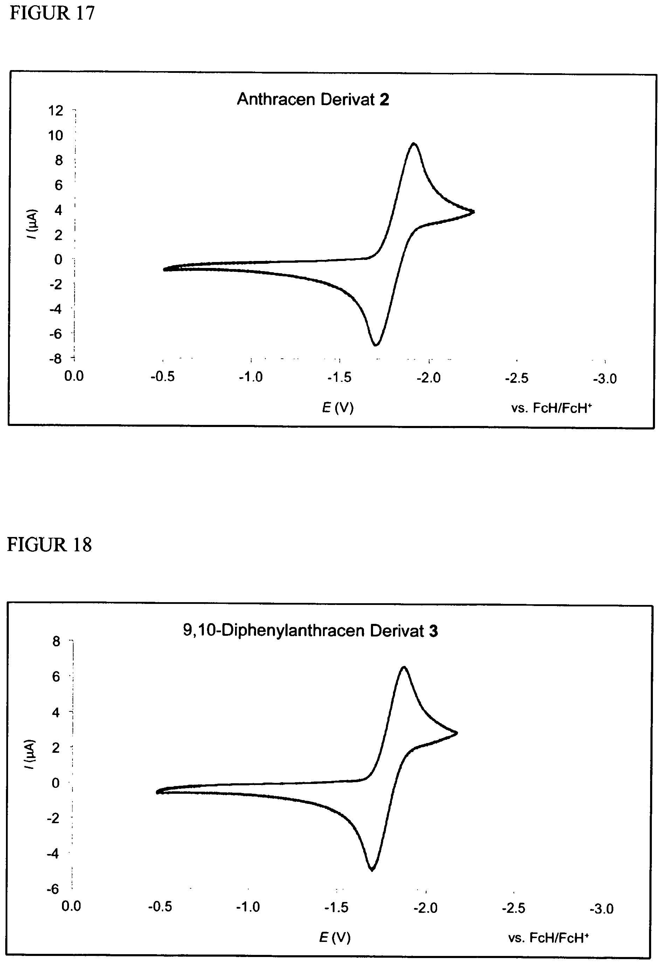

- Figur 17:: Cyclovoltammogramm des Anthracen Derivates **2** (THF, [*n*Bu₄N][PF₆] 0.1 M, 200 mV s⁻¹).
- Figur 18:: Cyclovoltammogramm des 9,10-Diphenylanthracen Derivates **3** (THF, [*n*Bu₄N][PF₆] 0.1 M, 200 mV s⁻¹).

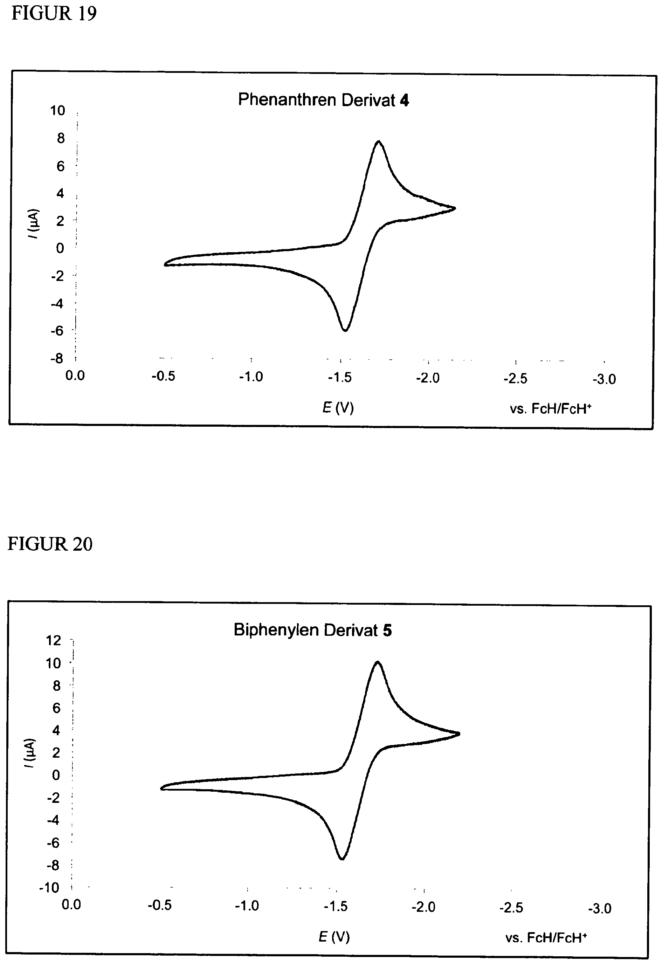

- Figur 19:: Cyclovoltammogramm des Phenanthren Derivates **4** (THF, [*n*Bu₄N][PF₆] 0.1 M, 200 mV s⁻¹).
- Figur 20:: Cyclovoltammogramm des Biphenylen Derivates **5** (THF, [*n*Bu₄N][PF₆] 0.1 M, 200 mV s⁻¹).

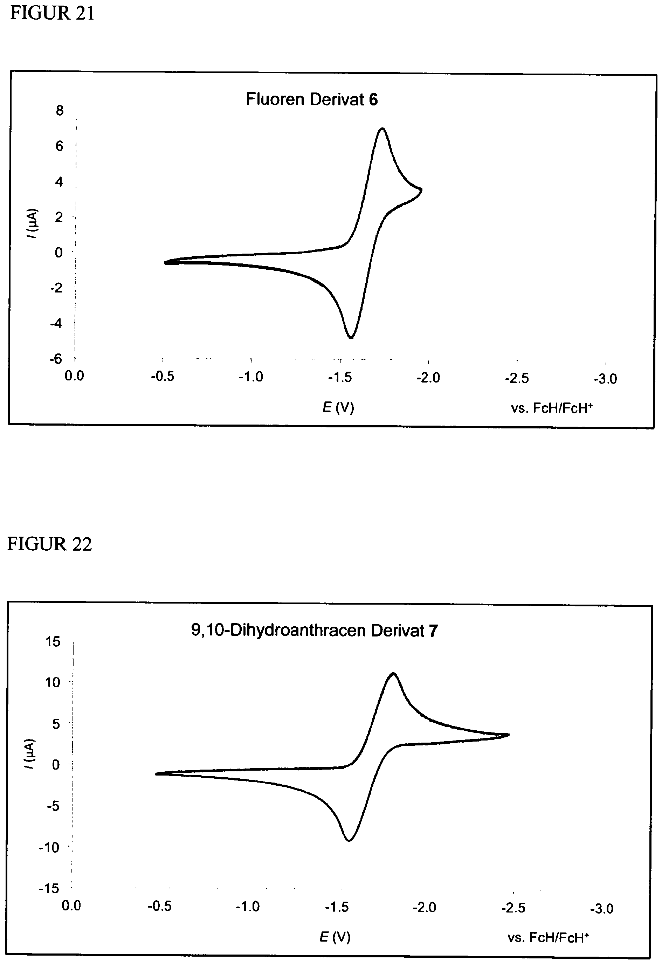

- Figur 21:: Cyclovoltammogramm des Fluoren Derivates **6** (THF,[*n*Bu₄N][PF₆]0.1 M, 200 mVs⁻¹).
- Figur 22:: Cyclovoltammogramm des 9,10-Dihydroanthracen Derivates **7** (THF, [nBu₄N][PF₆]0.1 M, 200 mVs⁻¹).

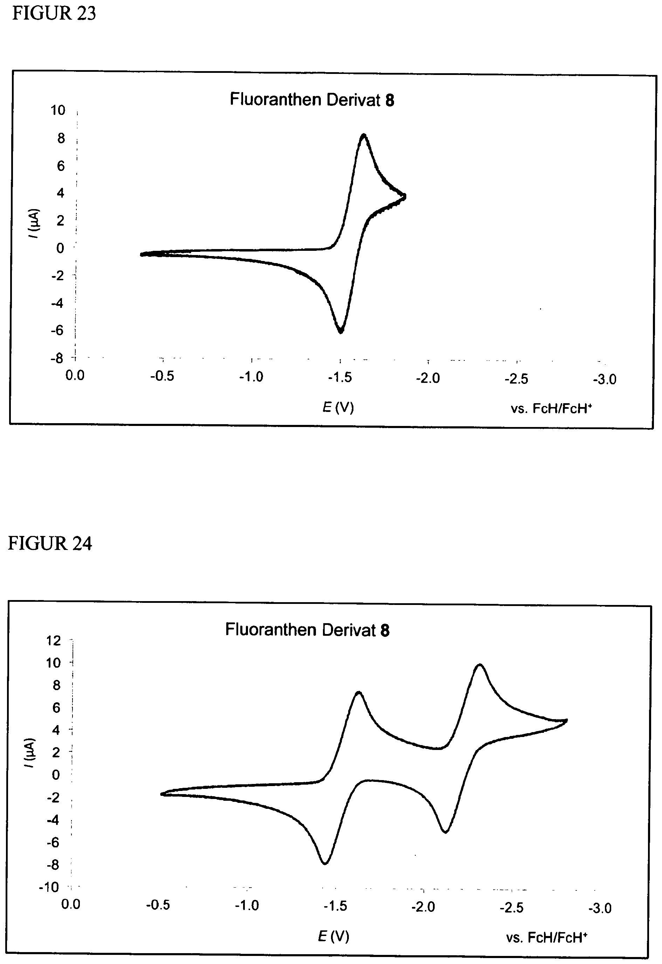

- Figur 23:: Cyclovoltammogramm des Fluoranthen Derivates **8** (CH₂Cl₂, [nBu₄N][PF₆]0.1 M, 200 mVs⁻¹).
- Figur 24:: Cyclovoltammogramm des Fluoranthen Derivates **8** (THF, [nBu₄N][PF₆]0.1 M, 200 mVs⁻¹).

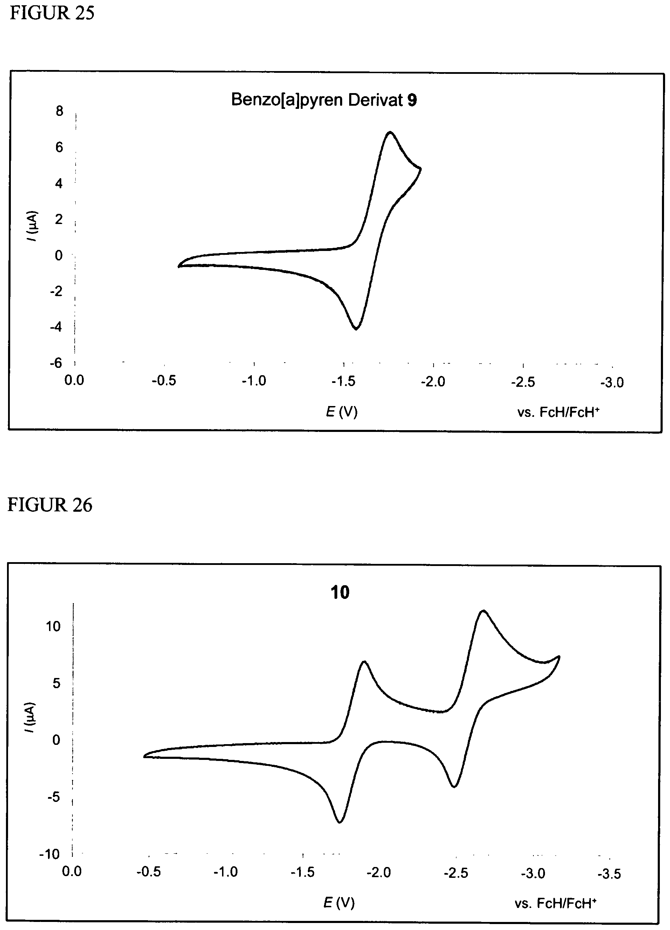

- Figur 25:: Cyclovoltammogramm des Benzo[a]pyren Derivates **9** (THF, [*n*Bu₄N][PF₆] 0.1 M, 200 mV s⁻¹).
- Figur 26:: Cyclovoltammogramm von Verbindung **10** (THF, [*n*Bu₄N][PF₆] 0.1 M, 200 mV s⁻¹).

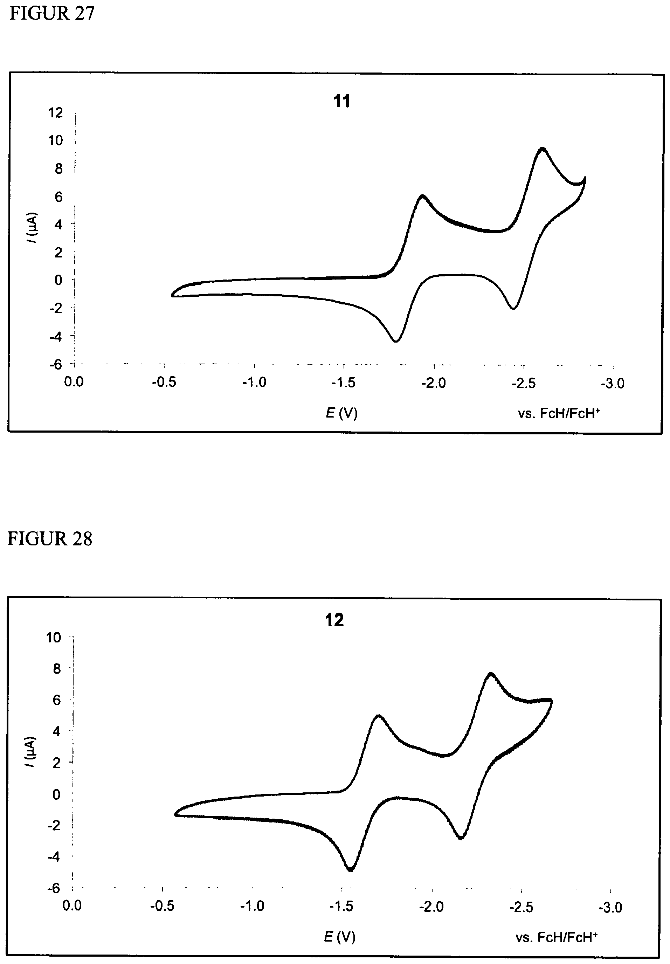

- Figur 27:: Cyclovoltammogramm von Verbindung **11** (THF, [*n*Bu₄N][PF₆] 0.1 M, 200 mV s⁻¹).
- Figur 28:: Cyclovoltammogramm von Verbindung **12** (THF, [*n*Bu₄N][PF₆] 0.1 M, 200 mV s⁻¹).

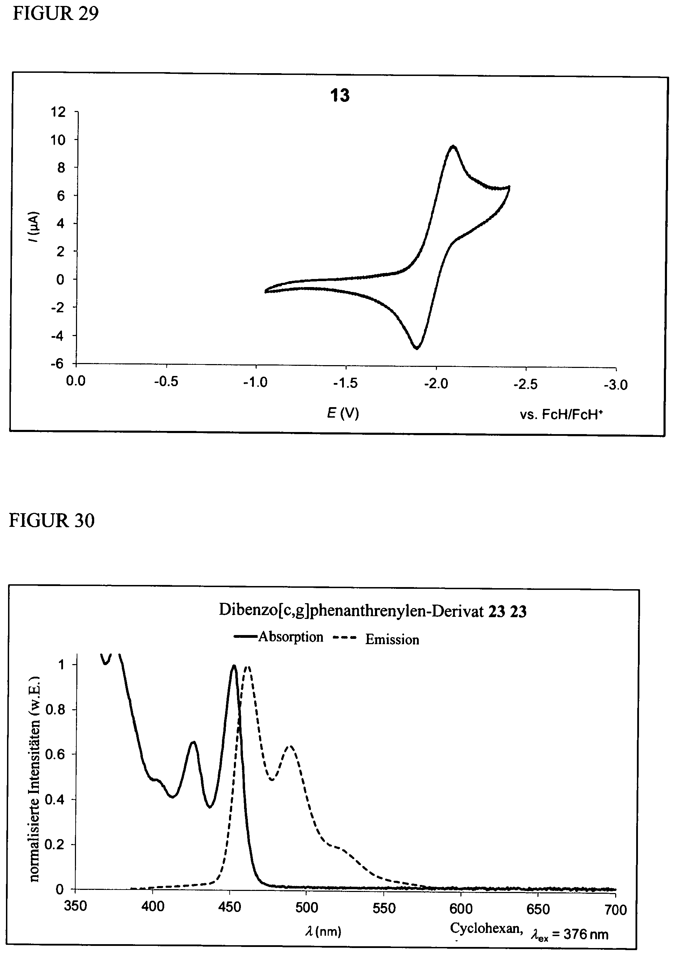

- Figur 29:: Cyclovoltammogramm von Verbindung **13** (THF, [*n*Bu₄N][PF₆] 0.1 M, 200 mV s⁻¹).
- Figur 30:: Normalisiertes UV-Absorptions- und Emissionsspektrum in Cyclohexan des Dibenzo[c,g]phenanthranylen-Derivats **23.**

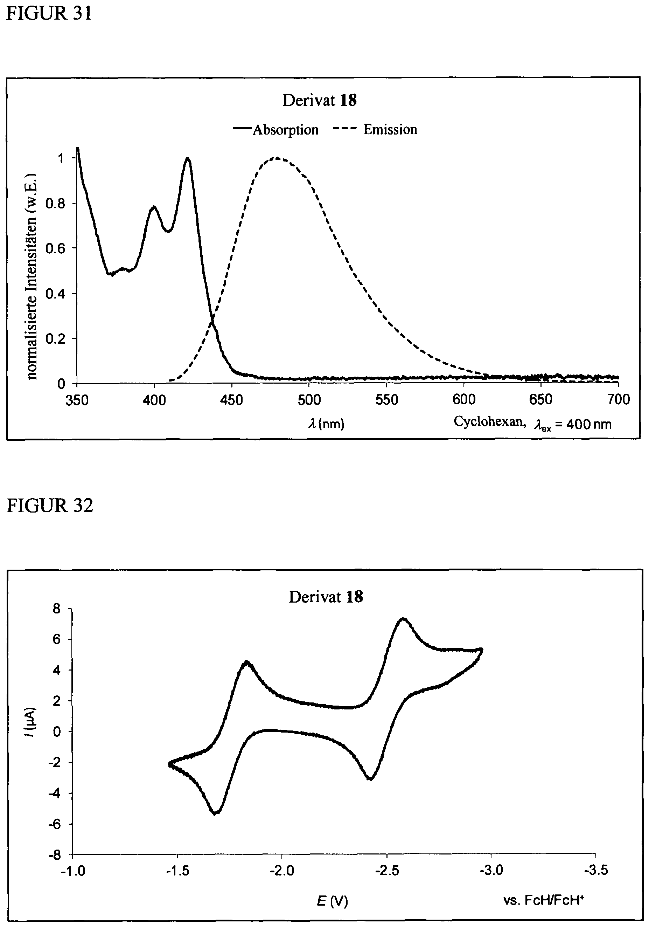

- Figur 31:: Normalisiertes UV-Absorptions- und Emissionsspektrum in Cyclohexan des Derivats **18.**
- Figur 32:: Cyclovoltammogramm von Derivat **18** (THF, [*n*Bu₄N][PF₆] 0.1 M, 200 mV s⁻¹).

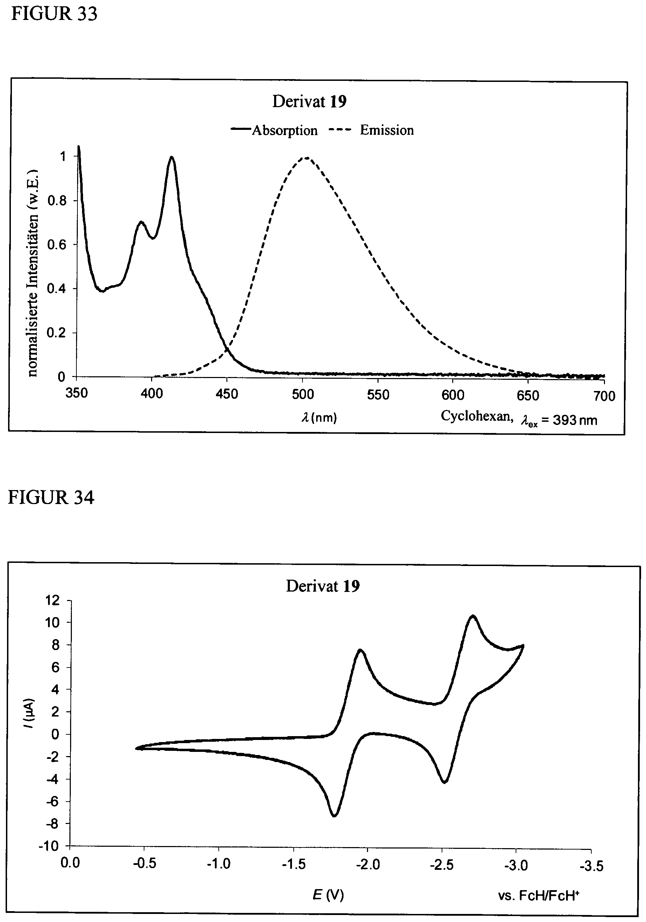

- Figur 33:: Normalisiertes UV-Absorptions- und Emissionsspektrum in Cyclohexan des Derivats **19.**
- Figur 34:: Cyclovoltammogramm von Derivat **19** (THF, [*n*Bu₄N][PF₆] 0.1 M, 200 mV s⁻¹).

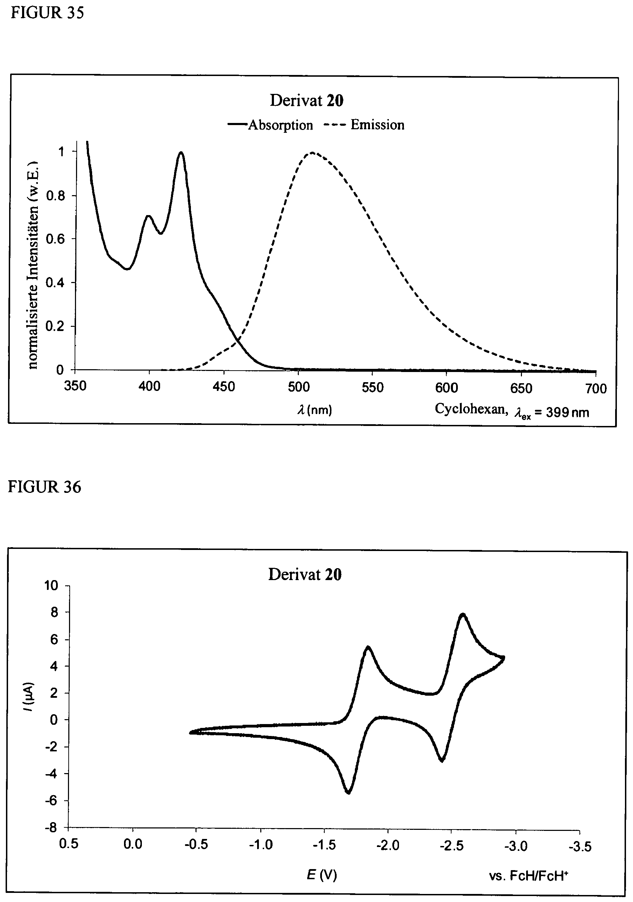

- Figur 35:: Normalisiertes UV-Absorptions- und Emissionsspektrum in Cyclohexan des Derivats **20.**
- Figur 36:: Cyclovoltammogramm von Derivat **20** (THF, [*n*Bu₄N][PF₆] 0.1 M, 200 mV s⁻¹).

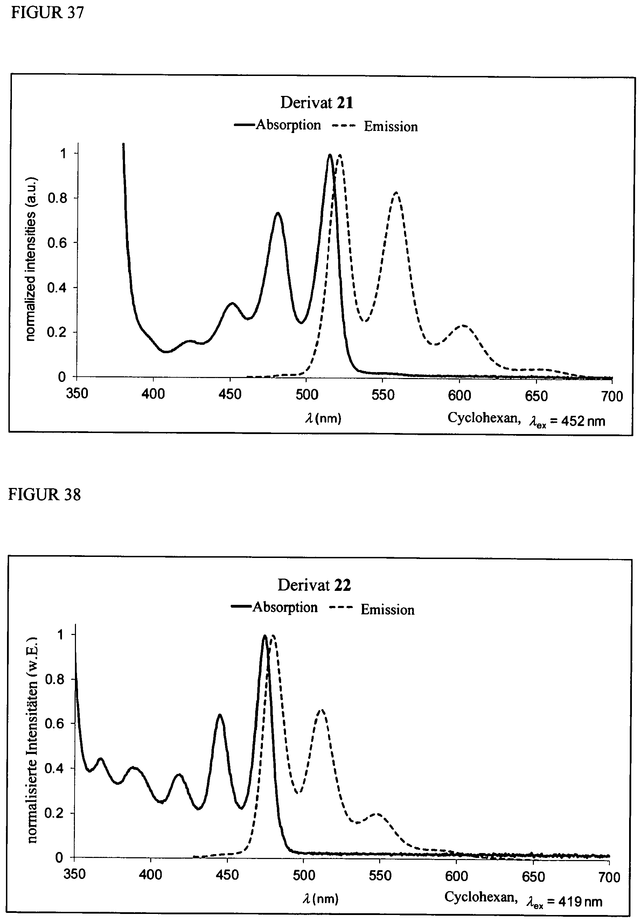

- Figur 37:: Normalisiertes UV-Absorptions- und Emissionsspektrum in Cyclohexan des Derivats **21.**
- Figur 38:: Normalisiertes UV-Absorptions- und Emissionsspektrum in Cyclohexan des Derivats **22.**

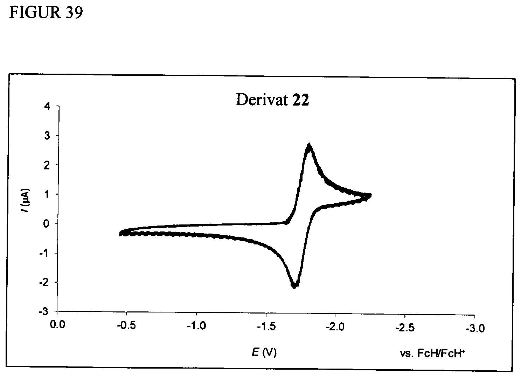

- Figur 39:: Cyclovoltammogramm von Derivat **22** (THF, [*n*Bu₄N][PF₆] 0.1 M, 200 mV s⁻¹).

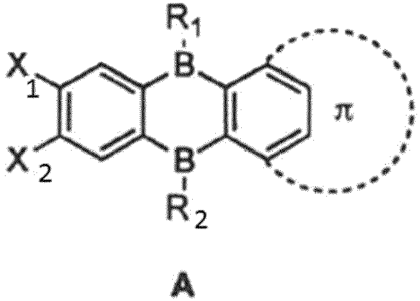

Über den genannten Syntheseweg konnten bereits die im Folgenden gezeigten Verbindungen des Strukturtyps A hergestellt werden. Der Einsatz weiter PAHs, wie beispielsweise Tetracen, Pentacen, Triptycene oder auch Triphenylen, ermöglicht es zusätzliche Derivate aufzubauen.

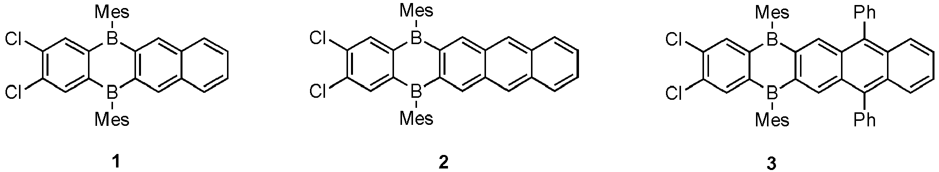

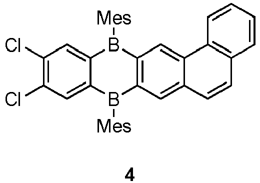

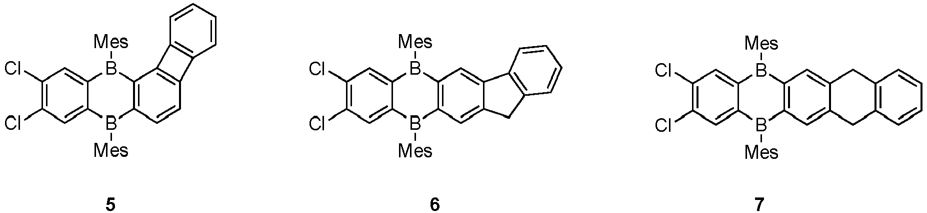

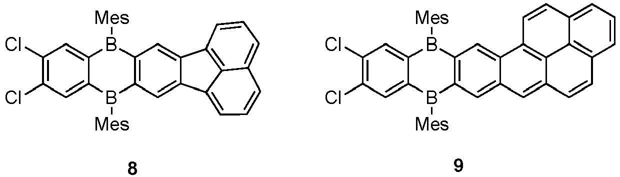

Die erhaltenen Verbindungen des Typs **A** können an den C-Cl-Positionen weiter funktionalisiert werden. Dadurch wird eine Einführung von Elektronendonoren, zum Beispiel substituierte Amine oder Thiophene möglich. Diese C-C-Kupplungsreaktion wurde bereits für das Naphthalin **1-,** Anthracen **2-** und Fluoranthen **8-** sowie das Phenanthren **4**-Derivat durchgeführt, wodurch die Verbindungen **10, 11, 12, 18** und **20** erhalten wurden.

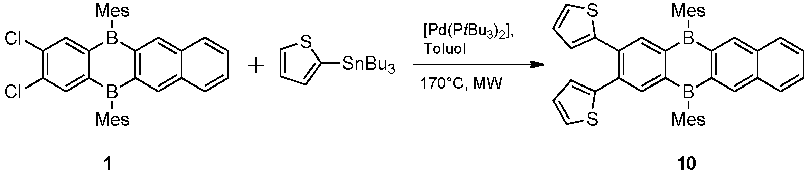

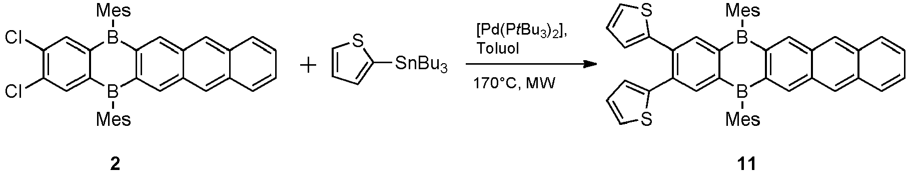

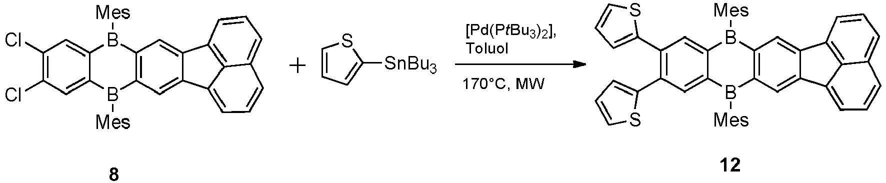

Neben der Einführung von Elektronendonoren über die Cl-Atome, ist zusätzlich eine Umsetzung von Heteroaromaten in der genannten Kaskadenreaktion möglich. Dadurch lassen sich weitere interessante Fluoreszenzfarbstoffe (nicht erfindungsgemäß) herstellen, so zum Beispiel:

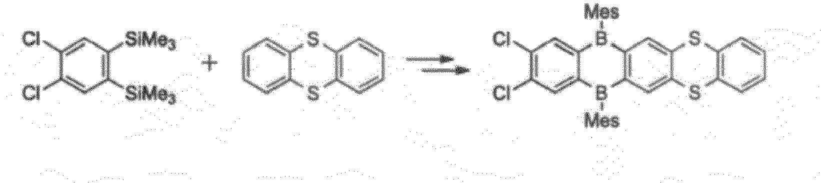

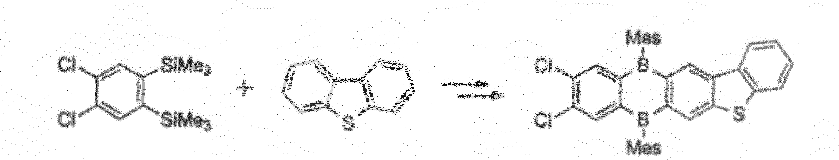

Zusätzlich zu einer Postfunktionalisierung lassen sich die Cl-Atome im Zuge einer Dehalogenierungsreaktion nachträglich entfernen um Arylborane vom Strukturtyp **13** zu erhalten.

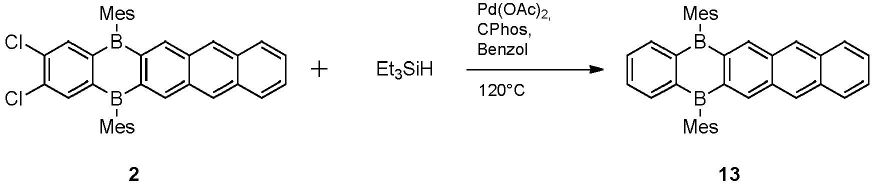

Des Weiteren, ist der Aufbau oligomerer bzw. polymerer Strukturen (nicht erfindungsgemäß) möglich, was den modularen Aufbau der Synthesesequenz weiter verdeutlicht. Hierfür bieten sich vor allem aromatische Kohlenwasserstoffe an, die ein hinreichend großes bzw. elektronisch entkoppeltes π-System besitzen.

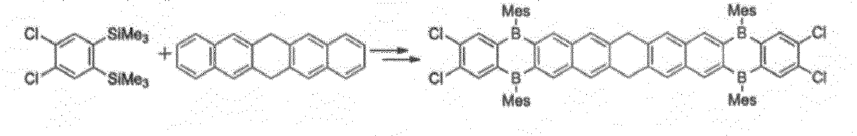

Weitere Derivate wurden analog zu der hierin beschriebenen Vorgehensweise hergestellt und mit üblichen Verfahren charakterisiert.

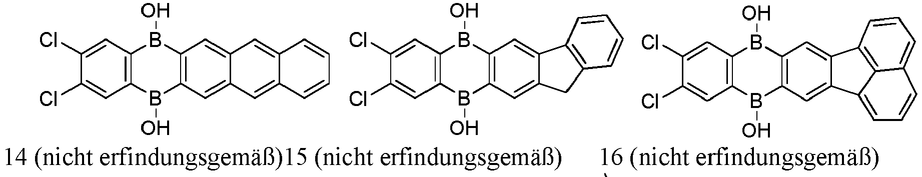

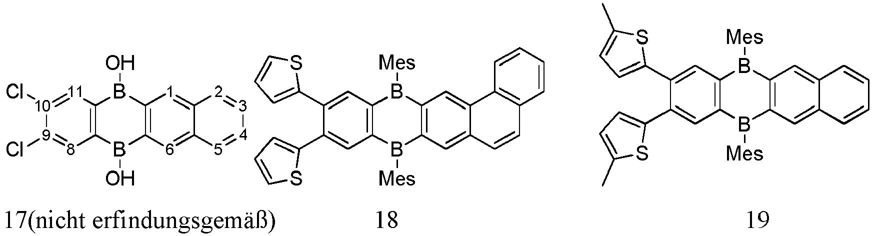

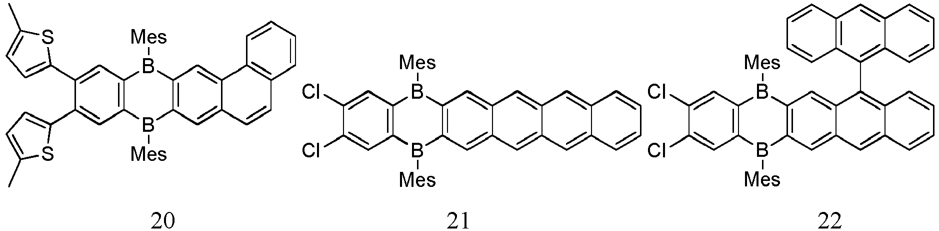

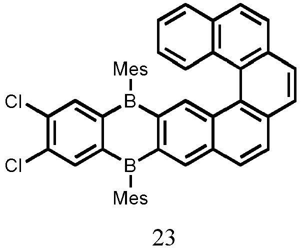

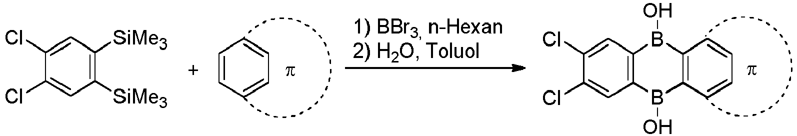

In einer abschmelzbaren Ampulle wurde 4,5-Dichlor-1,2-bis(trimethylsilyl)benzol, der entsprechende PAK, BBr₃ und *n*-Hexan zusammengegeben. Das Reaktionsgefäß wurde evakuiert und abgeschmolzen 2.5 Tage auf 120 °C in einem Ofen erhitzt. Die Ampulle wurde geöffnet, die dunkle Lösung in ein Schlenk-Gefäß überführt und alle flüchtigen Bestandteile im Ölpumpenvakuum entfernt. Der erhaltene Feststoff wurde in Toluol gelöst und unter Rühren mit dest. H₂O versetzt. Hierbei bildete sich ein Feststoff aus, der sich von der überstehenden Lösung durch Filtration abtrennen lässt. Um Reste des eingesetzten PAKs abzutrennen, wurde der Rückstand mit gängigen Lösungsmittel (CHCl₃, Cyclohexan) gewaschen. Die Wahl des Lösungsmittels hängt hierbei von der Löslichkeit des entsprechenden PAKs, sowie der gebildeten Borinsäure ab.

### Eigenschaften und Analytik der neuen Substanzen

### Löslichkeit

Die Löslichkeit der Verbindungen **1** bis **13** und **18** bis **23** sowie die Benzo[b]biphenyl Derivate ist in organischen Lösungsmitteln ausgezeichnet, besonders in CH₂Cl₂, CHCl₃ und aromatischen Lösungsmitteln wie Benzol. In Wasser und Alkoholen sind die Derivate **1** bis **13** und **18** bis **23** sowie die Benzo[b]biphenyl Derivate nicht, bzw. nur schlecht löslich.

### UV/Vis-, Fluoreszenzspektroskopie und Cyclovoltammetrie

**Tabelle 1: Photophysikalische und elektrochemische Daten ausgewählter Verbindungen. Alle optischen Messungen wurden in Cyclohexan durchgeführt. Reversible Redoxpotentiale wurden gegen Fc/Fc+ geeicht.**

| Derivat | *λ*_{abs} [nm] (*ε* [M⁻¹ cm⁻¹]) | *λ*ₑₓ [nm] | *λ*ₑₘ [nm] | *Φ*_{PL} [%]^{[a]} | *Stokes*-Shift [cm⁻¹] | *E*_{1/2} [V] ^{[b]} |
|---|---|---|---|---|---|---|
| **2** | 437 (6904) | 339 | 469 | 90 | 183 | -1.81 |
| | 465 (11048) | | 501 | | | |
| | | | 537 | | | |
| **3** | 430 (8773) | 403 | 498 | 87 | 454 | -1.78 |
| | 456 (14451) | | 532 | | | |
| | 487 (20156) | | | | | |
| **5** | 458 (15945) | 433 | 501 | 66 | 532 | -1.63 |
| | 488 (18849) | | 531 | | | |
| **8** | 411 (17745) | 313 | 464 | 51 | 1437 | -2.22 |
| | 435 (23074) | | 491 | | | -1.53 |
| **9** | 398 (14129) | 422 | 503 | 82 | 281 | -1.66 |
| | 422 (32548) | | 538 | | | |
| | 465 (16878) | | 578 | | | |
| | 496 (30012) | | | | | |
| **11** | 409 (10912) | 409 | 469 | 66 | 276 | -2.52 |
| | 435 (17022) | | 498 | | | -1.86 |
| | 463 (26251) | | 534 | | | |
| **13** | 380 (4072) | 335 | 456 | 82 | 194 | -1.99 |
| | 402 (4769) | | 486 | | | |
| | 425 (9476) | | 520 | | | |
| | 452 (15391) | | | | | |
| **19** | 392 (14212) | 393 | 503 | 54 | 4332 | -2.61 |
| | 413 (20266) | | | | | -1.86 |
| **21** | 424 | 452 | 521 | 62 | 261 | -/- |
| | 451 | | 558 | | | |
| | 481 | | 601 | | | |
| | 514 | | | | | |
| **22** | 367 (12249) | 419 | 479 | 89 | 220 | -1.75 |
| | 389 (11128) | | 510 | | | |
| | 419 (10243) | | 547 | | | |
| | 445 (17953) | | | | | |
| | 474 (28222) | | | | | |

| | | | | | | |
|---|---|---|---|---|---|---|
| [a] Die Quantenausbeute von 9,10-Diphenylanthracen wurde unter identischen Bedingungen auf ≥97% bestimmt. [b] Gemessen als Abstand zwischen dem Absorptionsmaximum mit der längsten Wellenlänge und dem entsprechenden Emissionsmaximum mit der kürzesten Wellenlänge. | | | | | | |

Wie aus den Werten in Tabelle 1 ersichtlich, besitzen die dargestellten Substanzen einen geringen *Stokes-Shift.* Da sich die Absorption und Emission der Verbindungen überlagern, zeigt sich im Fluoreszenzspektrum bei höheren Konzentrationen eine Verschiebung der gemessenen Schwerpunktswellenlänge in den grünen Bereich des Spektrums. Grund dafür ist die Reabsorption der im blauen Bereich emittierten Photonen.

Die in der vorliegenden Beschreibung, in den Figuren sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein.

## Patentansprüche

1. Verbindung der allgemeinen Formel 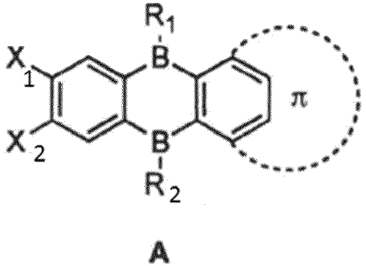
wobei X₁ und X₂ unabhängig voneinander ausgewählt sind aus der Gruppe, bestehend aus H, Cl, unsubstituiertem Thiophen und Thiophen, das mit einer oder mehreren Alkylgruppen substiutiert ist;
R₁ und R₂ unabhängig voneinander ausgewählt sind aus alkylsubstituierten Phenylgruppen, wobei
die gestrichelte Linie zusammen mit der Phenylgruppe, die mit den Enden der gestrichelten Linie verbunden ist, eine anellierte, aromatische Gruppe darstellt.

2. Verbindung nach Anspruch 1, wobei X₁ und X₂ unabhängig voneinander ausgewählt sind aus H, Cl; unsubstituiertem Thiophen und Thiophen, das mit einer oder mehreren Alkylgruppen substiutiert ist.

3. Verbindung nach Anspruch 1 oder 2, wobei R₁ und R₂ unabhängig voneinander ausgewählt sind aus alkylsubstituierten Phenylgruppen, vorzugsweise Mesityl und/oder 2,4,6-Tri(isopropyl)phenyl.

4. Verbindung nach einem der vorangehenden Ansprüche, wobei die anellierte, aromatische Gruppe ausgewählt ist aus Naphthylen, Anthracenylen, 9,10-Diphenylanthracenylen, Phenanthrenylen, Biphenylenylen, Fluorenylen, 9,10-Dihydroanthracenylen, Fluoranthenylen, Benzo[a]pyrenylen, Dibenzo[c,g]phenanthrenylen, Tetracenylen, 9,9`-Bianthracenylen oder Benzo[b]biphenylenylen.

5. Verfahren zur Herstellung einer Verbindung nach einem der Ansprüche 1 bis 4, umfassend die Schritte:
a) Umsetzen einer Verbindung der Formel 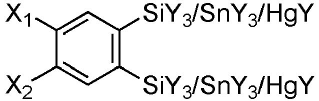 wobei jedes Y unabhängig ausgewählt ist aus der Gruppe, bestehend aus H, Alkyl und Aryl mit einer anellierten, aromatischen Verbindung und BBr₃, um ein Zwischenprodukt zu erhalten; und
b) Umsetzen des Zwischenprodukts mit R₁MgBr, R₁Li, R₁Cu, R₁-Zn-R₁, R₁-Cd-R₁, R₁-Hg-R₁, (R₁)₃-Bi, (R₁)₃-Sb oder einem Gemisch derselben und/oder R₂MgBr, R₂Li, R₂Cu, R₂-Zn-R₂, R₂-Cd-R₂, R₂-Hg-R₂, (R₂)₃-Bi, (R₂)₃-Sb oder einem Gemisch derselben, um die Verbindung nach einem der Ansprüche 1 bis 4 zu erhalten.

6. Organische Leuchtdiode, umfassend eine Verbindung nach einem der Ansprüche 1 bis 4.

7. Organische Leuchtdiode nach Anspruch 6, umfassend eine Emissionsschicht, wobei die Verbindung nach einem der Ansprüche 1 bis 4 in der Emissionsschicht angeordnet ist.

8. Verwendung einer Verbindung nach einem der Ansprüche 1 bis 4 als Fluorenszenzfarbstoff, als Elektrolumineszenzmittel oder in organischen n-Typ Halbleitern.

## Claims

1. A compound of the general formula 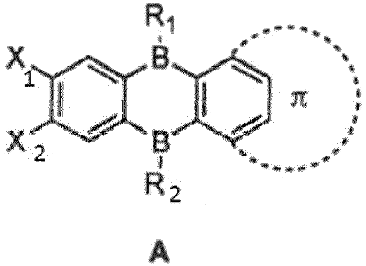
wherein X₁ and X₂ are independently selected from the group consisting of H, Cl, unsubstituted thiophene and thiophene substituted with one or more alkyl groups;
R₁ and R₂ are independently selected from alkyl-substituted phenyl groups, wherein
the dashed line together with the phenyl group connected to the ends of the dashed line represents a fused aromatic group.

2. The compound according to claim 1, wherein X₁ and X₂ are independently selected from H, Cl; unsubstituted thiophene and thiophene substituted with one or more alkyl groups.

3. The compound according to claim 1 or 2, wherein R₁ and R₂ are independently selected from alkyl-substituted phenyl groups, preferably mesityl and/or 2,4,6-tri(isopropyl)phenyl.

4. The compound according to any one of the preceding claims, wherein the fused aromatic group is selected from naphthylene, anthracenylene, 9,10-diphenylanthracenylene, phenanthrenylene, biphenylenylene, fluorenylene, 9,10-dihydroanthracenylene, fluoranthenylene, benzo[a]pyrenylene, dibenzo[c,g]phenanthrenylene, tetracenylene, 9,9'-bianthracenylene or benzo[b]biphenylenylene.

5. A process for preparing a compound according to any one of claims 1 to 4, comprising the steps of:
a) reacting a compound of the formula 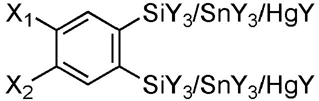 wherein each Y is independently selected from the group consisting of H, alkyl and aryl with a fused aromatic compound and BBr3 to obtain an intermediate; and
b) reacting the intermediate with R₁MgBr, R₁Li, R1Cu, R₁-Zn-R₁, R₁-Cd-R₁, R₁-Hg-R₁, (R₁)₃-Bi, (R₁)₃-Sb or a mixture thereof and/or R₂MgBr, R₂Li, R₂Cu, R₂-Zn-R₂, R₂-Cd-R₂, R₂-Hg-R₂, (R₂)₃-Bi, (R₂)₃-Sb or a mixture thereof to obtain the compound according to any one of claims 1 to 4.

6. An organic light emitting diode comprising a compound according to any one of claims 1 to 4.

7. The organic light emitting diode according to claim 6, comprising an emission layer, wherein the compound according to any one of claims 1 to 4 is arranged in the emission layer.

8. Use of a compound according to any one of claims 1 to 4 as a fluorence dye, as an electroluminescent agent or in organic n-type semiconductors.

## Revendications

1. Composé répondant à la formule générale 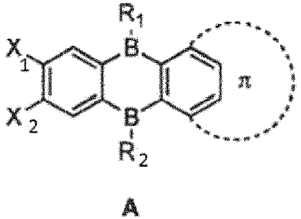
dans laquelle X₁ et X₂ sont choisis, indépendamment l'un de l'autre, dans le groupe constitué de H, CI, de thiophène non-substitué et de thiophène substitué avec un ou plusieurs groupes alkyle ;
R₁ et R₂ sont choisis, indépendamment l'un de l'autre, de groupes phényle substitués à l'alkyle,
la ligne en pointillé représentant, ensemble avec le groupe phényle relié aux terminaisons de ladite ligne en pointillé, un groupe aromatique annelé.

2. Composé selon la revendications 1, X₁ et X₂ étant choisis, indépendamment l'un de l'autre, parmi H, Cl ; du thiophène non-substitué et du thiophène substitué avec un ou plusieurs groupes alkyle.

3. Composé selon les revendications 1 ou 2, R₁ et R₂ étant choisis, indépendamment l'un de l'autre, parmi les groupes phényle substitués à l'alkyle, s'agissant préférentiellement de mésityle et/ou de 2,4,6-tri(isopropyl)phényle.

4. Composé selon l'une des revendications précédentes, ledit groupe aromatique annelé étant choisi parmi le naphtylène, l'anthracénylène, le 9,10-diphénylanthracénylène, le phénanthrénylène, le biphénylénylène, le fluorénylène, le 9,10-dihydroanthracénylène, le fluoranthénylène, le benzo[a]pyrénylène, le dibenzo[c,g]phénanthrénylène, le tétracénylène, le 9,9'-bis-anthracénylène ou le benzo[b]biphénylénylène.

5. Procédé de préparation d'un composé selon l'une des revendications 1 à 4, comprenant les étapes consistant à :
a) faire réagir un composé répondant à la formule 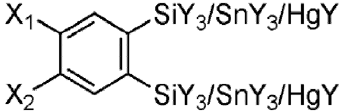 dans laquelle chaque Y est choisi, de manière indépendante, dans le groupe constitué de H, d'alkyle et d'aryle, avec un composé aromatique annelé et avec BBr₃, afin d'obtenir un produit intermédiaire ; et
b) faire réagir ledit produit intermédiaire avec du R₁MgBr, R₁Li, R₁Cu, R₁-Zn-R₁, R₁-Cd-R₁, R₁-Hg-R₁, (R₁)₃-Bi, (R₁)₃-Sb ou avec un mélange de ceux-ci et/ou avec du R₂MgBr, R₂Li, R₂Cu, R₂-Zn-R₂, R₂-Cd-R₂, R₂-Hg-R₂, (R₂)₃-Bi, (R₂)₃-Sb ou avec un mélange de ceux-ci, afin d'obtenir un composé selon l'une des revendications 1 à 4.

6. Diode électroluminescent organique, comprenant un composé selon l'une des revendications 1 à 4.

7. Diode électroluminescente organique selon la revendication 6, comprenant une couche d'émission, le composé selon l'une des revendications 1 à 4 étant disposé au sein de ladite couche d'émission.

8. Utilisation d'un composé selon l'une des revendications 1 à 4 en tant que colorant de fluorescence, en tant qu'agent d'électrofluorescence ou dans des semi-conducteurs de type n.
